(19) Europäisches Patentamt / European Patent Office / Office européen des brevets

(11) **EP 4 383 604 A1**

(12) **EUROPEAN PATENT APPLICATION**
published in accordance with Art. 153(4) EPC

(43) Date of publication:
**12.06.2024 Bulletin 2024/24**

(21) Application number: **22867573.2**

(22) Date of filing: **08.08.2022**

(51) International Patent Classification (IPC):
**H04L 1/00** (2006.01)    **H04L 47/34** (2022.01)
**H04L 47/36** (2022.01)

(52) Cooperative Patent Classification (CPC):
**H04L 1/00; H04L 47/34; H04L 47/36**

(86) International application number:
**PCT/KR2022/011761**

(87) International publication number:
**WO 2023/038304 (16.03.2023 Gazette 2023/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.09.2021 KR 20210120393**

(71) Applicant: **Samsung Electronics Co., Ltd.**
**Suwon-si, Gyeonggi-do 16677 (KR)**

(72) Inventors:
• **JANG, Min**
**Suwon-si, Gyeonggi-do 16677 (KR)**

• **KIM, Hyunil**
**Suwon-si, Gyeonggi-do 16677 (KR)**
• **SHIN, Jaewook**
**Suwon-si, Gyeonggi-do 16677 (KR)**
• **YANG, Hayoung**
**Suwon-si, Gyeonggi-do 16677 (KR)**
• **CHOI, Youngkwan**
**Suwon-si, Gyeonggi-do 16677 (KR)**

(74) Representative: **HGF**
**HGF Limited**
**1 City Walk**
**Leeds LS11 9DX (GB)**

(54) **METHOD AND DEVICE FOR TRANSMITTING OR RECEIVING SIGNAL IN COMMUNICATION SYSTEM**

(57)    The present disclosure relates to a communication technique for merging IoT technology with a 5G communication system for supporting higher data transmission rates than 4G systems, and a system therefor. The present disclosure may be applied to intelligent services (e.g., smart homes, smart buildings, smart cities, smart cars or connected cars, health care, digital education, retail businesses, and security and safety-related services) on the basis of 5G communication technologies and IoT-related technologies. A method performed by a reception device of a communication system according to an embodiment of the present invention comprises the steps of: obtaining a first sequence on the basis of a received signal; comparing the length of the first sequence with an operation unit; when the length of the first sequence is smaller than the operation unit, generating a second sequence on the basis of the first sequence; and performing decoding on the basis of the second sequence, wherein the length of the second sequence is greater than or equal to the operation unit.

| 110 | 120 |
| TRANSMISSION NODE | → | RECEPTION NODE |

FIG. 1

**Description**

**[Technical Field]**

The disclosure relates to error-correction codes for correcting or restoring data when errors and loss of data may occur or are likely to occur, due to various causes such as noise, interference, or the like in a process of transmitting or storing data. Particularly, the disclosure relates to encoding and decoding of a low-density parity-check (LDPC) code, and more particularly, to efficiently implementing a method, a procedure and an apparatus for encoding and transmitting a signal in a mobile communication system and a broadcasting system, and a method, a procedure, and an apparatus for receiving and decoding the transmitted signal.

**[Background Art]**

Efforts are being made to develop an improved 5th generation (5G) communication system or a pre-5G communication system in order to meet ever-increasing demands for wireless data traffic after commercialization of 4th generation (4G) communication systems. For this reason, a 5G communication system or a pre-5G communication system is referred to as a beyond 4G network communication system or a post LTE (long term evolution) system.

To achieve a high data transfer rate, 5G communication systems are being considered for implementation in ultra-high frequency (mmWave) bands (e.g., 28 GHz or 60 GHz bands). In order to mitigate the propagation path loss of radio waves and increase the transmission distance of radio waves in the ultra-high frequency bands, beamforming, massive multiple-input multiple-output (massive MIMO), full dimensional MIMO (FD-MIMO), array antenna, analog beamforming, and large-scale antenna technologies are being discussed in the 5G communication systems.

Furthermore, for improving networking of the system, technologies such as evolved small cell, advanced small cell, cloud radio access network (RAN), ultra-dense network, device-to-device (D2D) communication, wireless backhaul, moving network, cooperative communication, coordinated multi-points (CoMP), and interference cancellation are being developed for the 5G communication systems.

In addition, in the 5G system, hybrid frequency shift keying and quadrature amplitude modulation (FQAM) and sliding window superposition coding (SWSC), which are advanced coding modulation (ACM) schemes, and filter bank multi carrier (FBMC), non-orthogonal multiple access (NOMA), and sparse code multiple access (SCMA), which are advanced access technologies, are being developed.

Meanwhile, the Internet is further evolving from a human-centered network of connections in which persons generate and consume information to an Internet of Things (IoT) network where information is exchanged and processed between distributed components such as things. Recently, an Internet of Everything (IoE) technology is also emerging in which a big data processing technology is combined with IoT technology over connections with cloud servers. To implement such an IoT, technical elements such as sensing technology, wired and wireless communication and network infrastructure, service interface technology, and security technology are required, and thus recently, technologies such as sensor network, machine to machine (M2M), and machine type communication (MTC) have been researched for connection between things. Such an IoT environment may provide intelligent IT (Internet Technology) services capable of creating a new value for human life by collecting and analyzing data generated by connected objects. The IoT may be also applied to various fields such as e.g., smart homes, smart buildings, smart cities, smart or connected cars, smart grids, healthcare, smart appliances, advanced medical services and so on, using convergence and combination between existing information technology (IT) and various industries.

As such, various attempts have been made to apply the 5G communication system to the IoT network. For example, technologies such as a sensor network, machine-to-machine (M2M) communication, machine type communication (MTC), and the like are being implemented by the 5G communication technologies such as e.g., beamforming, MIMO, and array antennas. Such an application of a cloud radio access network (cloud RAN) as the big data processing technology described above may be referred to as an example of a convergence between the 5G technology and the IoT technology.

In general, when data is transmitted and received between a transmitter and a receiver in a communication and broadcasting system, a data error may occur due to noise present in its communication channel. As such, there are error detection codes and error correction codes (ECC) schemes as the encoding methods designed to correct errors generated by communication channels at a receiver side. In particular, such error correction codes used for communication between transceivers are generally referred to as channel coding or forward error correction (FEC). The transmitter serves to encode a data bit sequence to be transmitted to generate and transmit a codeword bit sequence of a longer length, and the receiver serves to decode the codeword bit sequence mixed with errors or noise to overcome the errors or noise and estimate the dating bit sequence.

Various channel coding techniques are being used in communication and broadcasting systems. Channel coding schemes used today may include convolutional code, turbo code, low-density parity-check coding (LDPC code), polar code or the like. Among these channel coding techniques, the LDPC code shows superior error correction performance compared to other channel coding techniques, as the length of the code increases. In addition, the LDPC code is more suitable for parallelization in the code structure and its resulting belief-propagation (BP) decoding operation, and thus is very suitable for use in an application system requiring high-throughput. Owing to these advantages, LDPC codes are commonly used in various communication and broadcasting systems such as IEEE 802.11n/ad Wi-Fi, DVB-T2/C2/S2, ATSC 3.0 and so on, and in particular, have recently been adopted and also used in 3GPP New Radio (NR) systems, which are 5G mobile communication systems. The disclosure relates to a method for effectively encoding a signal with an LDPC code and for effectively decoding a signal encoded with the LDPC code.

**[Detailed Description of Invention]**

**[Technical Problem]**

The disclosure provides an apparatus and a method for efficiently encoding a signal with a low-density parity-check (LDPC) code in a communication or broadcasting system, and an apparatus and a method for efficiently decoding a signal encoded with the LDPC code. Upon performing a hybrid automatic repeat and request (HARQ) operation using an LDPC code, the encoding or decoding operation may be interrupted or may not produce a normal result, in case where a size of an incremental redundancy bit transmitted at a specific time point is less than a minimum unit processed by an LDPC encoder and decoder. This problem may occur, in particular, in LDPC encoders and decoders implemented with hardware having a fixed structure, and this problem needs to be addressed because in case that the LDPC encoders and decoders do not function properly due to the above problem, the overall performance and reliability of the system may be lowered.

**[Technical Solution]**

According to an embodiment of the disclosure, for addressing the aforementioned problems, a method performed by a receiving device of a communication system comprises obtaining a first sequence based on a received signal; comparing a length of the first sequence with an operating unit; when the length of the first sequence is less than the operating unit, generating a second sequence based on the first sequence; and performing decoding based on the second sequence, wherein the length of the second sequence is greater than or equal to the operating unit.

Further, according to an embodiment of the disclosure, a receiving device of a communication system comprises a transceiver; and a controller configured to obtain a first sequence based on a received signal, compare a length of the first sequence with an operating unit, generate a second sequence based on the first sequence when the length of the first sequence is less than the operating unit, and perform decoding based on the second sequence, wherein the length of the second sequence is greater than or equal to the operating unit.

Further, according to an embodiment of the disclosure, a method performed by a transmitting device of a communication system comprises identifying a length of a bit sequence for performing transmission; comparing the length of the bit sequence for performing transmission with an operating unit; when the length of the bit sequence for performing the transmission is less than the operating unit, generating a second bit sequence having a length greater than or equal to the operating unit; generating a first bit sequence having a length of the bit sequence for performing the transmission, based on the second bit sequence; and transmitting a signal based on the first bit sequence.

Further, according to an embodiment of the disclosure, a transmitting device of a communication system comprises a transceiver; and a controller configured to identify a length of a bit sequence for performing transmission, compare the length of the bit sequence for performing the transmission with an operating unit, when the length of the bit sequence for performing the transmission is less than the operating unit, generate a second bit sequence having a length greater than or equal to the operating unit, generate a first bit sequence having a length of the bit sequence for performing the transmission, based on the second bit sequence, and transmit a signal based on the first bit sequence.

**[Advantageous Effects]**

An apparatus and a method according to various embodiments of the disclosure may normally process an input sequence (bit sequence, LLR sequence, etc.) less than a minimum operating unit determined for an operation of an encoder and a decoder, thereby preventing the encoder and the decoder from stopping or operating incorrectly. Accordingly, the transceiver including the LDPC code encoder and e decoder of the disclosure may operate in a stable condition, thereby improving the reliability of the system.

**[Brief Description of Drawings]**

FIG. 1 is a diagram illustrating a wireless communication system according to various embodiments of the disclosure.

FIG. 2A is a diagram illustrating an example of a configuration of a receiver performing communication in a wireless communication system according to various embodiments of the disclosure.

FIG. 2B is a diagram illustrating an example of a configuration of a transmitter performing communication in a wireless communication system according to various embodiments of the disclosure.

FIG. 3 is a diagram illustrating an embodiment of a parity check matrix of an LDPC code.

FIG. 4 is a diagram schematically showing a binary graph corresponding to the parity check matrix of FIG. 3.

FIG. 5 is a diagram illustrating an example of a parity check matrix of a QC-LDPC code.

FIG. 6 is a diagram illustrating a process of performing a decoding including pre-processing according to conditions in an embodiment of the disclosure.

FIG. 7 is a sequence diagram illustrating a process of performing a decoding after a series of pre-processing according to an embodiment of the disclosure.

FIG. 8 is a diagram illustrating a rectangular buffer configured in an interleaving process performed in an embodiment of the disclosure.

FIG. 9 is a flowchart illustrating a process of performing a series of pre-processing and then decoding based on a predetermined length according to an embodiment of the disclosure.

FIG. 10 is a diagram illustrating a process of performing encoding including post-processing according to conditions in an embodiment of the disclosure.

FIG. 11 is a diagram illustrating a process of performing a post-processing according to an embodiment of the disclosure.

**[Mode For Carrying Out Invention]**

Hereinafter, embodiments of the disclosure will be described in detail with reference to the accompanying drawings.

In describing embodiments, description of technical contents that are well known in the art to which the disclosure pertains and are not directly related to the disclosed invention will be omitted. This is to convey the subject matter of the disclosed invention more clearly without obscuring the same by omitting unnecessary description.

For the same or similar reasons, some elements in the accompanying drawings may be emphasized, omitted, or schematically illustrated. Further, the size of each component may not entirely reflect the actual size. In each drawing, the same or like components are denoted by the same reference numerals.

Advantages and features of the disclosure and methods of achieving the same will become apparent, referring to the embodiments described below in detail with reference to the accompanying drawings. However, the disclosure is not limited to the embodiments disclosed below, but may be implemented in various different forms, and the present disclosure is provided only to make the disclosure more complete and to fully inform a person skilled in the art of the scope of the claimed invention, which is defined only by the scope of the claims. Throughout the specification, the same reference numerals refer to the same components.

In this context, it will be understood that operations of each block of the flowcharts and combinations of the blocks in the flowcharts may be performed by computer program instructions. Since those computer program instructions may be mounted on a processor of a general-purpose computer, a special-purpose computer, or other programmable data processing equipment, the computer may also generate a means by which the instructions executed via the processor of the other programmable data processing equipment perform the functions described in block(s) of the flowcharts. These computer program instructions may be stored in a computer-usable or computer-readable memory that may be directed to a computer or other programmable data processing equipment to implement a function in a specific manner, and thus the instructions stored in the computer-usable or computer-readable memory may also produce a manufacturing item including therein instruction means that perform the function described in the flowchart block(s). The computer program instructions may be mounted onto a computer or any other programmable data processing equipment, and therefore, the instructions causing the computer or other programmable data processing equipment to perform a series of steps of operation thereon to create a process executable by the computer may also provide steps for performing the functions described in the flowchart block(s).

Further, each block may represent a module, a segment, or a portion of a code including one or more executable instructions for executing a specified logical function(s). It should also be noted that in some alternative execution examples, the functions mentioned in the blocks may occur out of the sequence. For example, two blocks shown one after another may actually be performed substantially simultaneously, or the blocks may sometimes be performed in reverse order depending on their corresponding functions.

In this context, the term '~ unit (or part)' used in embodiments of the disclosure may mean software or a hardware component such as e.g., FPGA or ASIC, to perform a certain function. However, the '~ unit' does not mean that it is limited only to such software or hardware. The '~ unit' may be configured to reside in an addressable storage medium or may be configured to reproduce one or more processors. Thus, as an example, the '~ unit' may include components such as e.g., software components, object-oriented software components, class components, and task components, processes, functions, attributes, procedures, subroutines, segments of program code, drivers, firmware, micro-codes, circuits, data, databases, data structures, tables, arrays, variables and so on. Functions provided within those components and the '~ unit' may be combined into a smaller number of components and '~ units (or parts)' or may be further separated into additional components and '~ units (or parts)'. In addition, the components and '~units (or parts)' may be implemented to reproduce one or more CPUs in a device or a secure multimedia card.

Hereinafter, various embodiments will be described in detail below with reference to the accompanying drawings, wherein it should be noted that in the accompanying drawings, the same components are denoted by the same reference numerals wherever possible. It should also be noted that the accompanying drawings of the disclosure are provided to assist in understanding the present invention, and that the disclosed invention is not limited only to the form or arrangement illustrated in the accompanying drawings. Furthermore, detailed descriptions of the known features and configurations that may obscure the subject matter of the disclosed invention will be omitted for convenience of explanation. It should be understood that in the following description, only those portions necessary to understand the operation of various embodiments of the disclosed invention will be described, and description of other portions will be omitted so as not to obscure the gist of the disclosed invention.

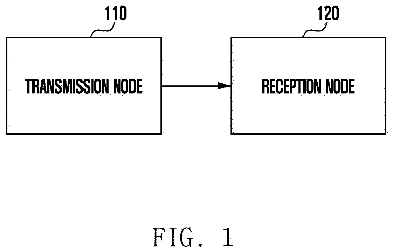

FIG. 1 is a diagram illustrating an example of a wireless communication system according to various embodiments of the disclosure.

Referring to FIG. 1, the communication system may include a transmission node (or transmitter or transmitting device) 110 and a reception node (or receiver or receiving device) 120 as a part of devices or nodes using a wireless channel in the wireless communication system according to an embodiment of the disclosure. FIG. 1 illustrates one transmission node 110 and one reception node 120, but it is only for illustrative purposes and the disclosure may also be applied to a communication system including a plurality of transmission nodes or a plurality of reception nodes. Further, while the disclosure describes that the transmission node 110 and the reception node 120 are separate entities for convenience of description, the functions of the transmission node 110 and the reception node 120 may be interchangeable. That is, depending on the situation, the transmission node illustrated in FIG. 1 may function as a reception node, or the reception node may function as a transmission node. For example, in the case of an uplink of a cellular communication system, the transmission node 110 may be a terminal, and the reception node 120 may be a base station. In the case of a downlink, the transmission node 110 may be a base station, and the reception node 120 may be a terminal. Alternatively, in the case of a sidelink, both the transmission node 110 and the reception node 120 may be a terminal.

In various embodiments, the transmission node 110 may generate a codeword by encoding information bits based on an LDPC code, and the reception node 120 may decode a signal of the received codeword based on the LDPC code. For example, the reception node 120 may use an LDPC decoding scheme according to the disclosure, and may perform a syndrome check to determine whether its decoding result is normal. The transmission node 110 and the reception node 120 may perform the LDPC encoding and decoding using a parity check matrix known to each other. For example, the parity check matrix may include the parity check matrix defined in the 5G NR standard, for example, TS 38.212, etc.

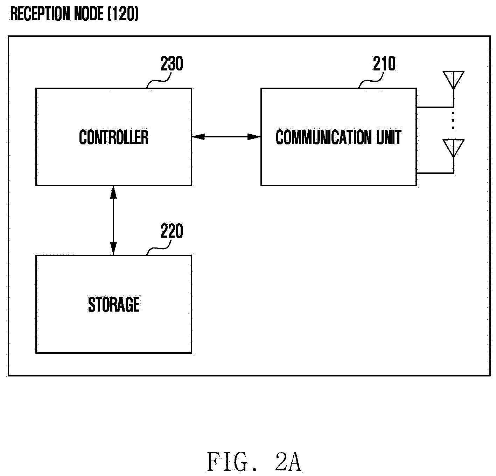

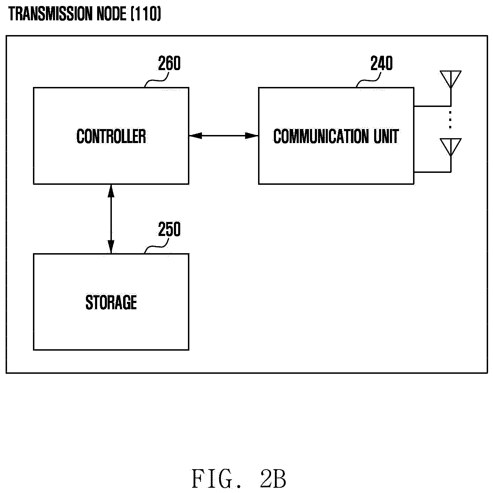

FIGS. 2A and 2B each illustrate an example of a configuration of an apparatus for performing communications in a wireless communication system according to various embodiments of the disclosure. As used herein, the terms '~ unit', '~ part', '~ er' and so on may refer to a unit that processes at least one function or operation, which may be implemented by hardware, software, or a combination of hardware and software.

FIG. 2A is a diagram illustrating an example of a configuration of a receiving device performing communications in a wireless communication system according to various embodiments of the disclosure.

Referring to FIG. 2A, the receiving device 120 may include a communication unit 210, a storage 220, and a controller 230.

The communication unit 210 may perform functions for transmitting and receiving signals over a wireless channel. For example, the communication unit 210 may perform a conversion function between a baseband signal and a bit stream according to a physical layer specification of the system. For example, when transmitting data, the communication unit 210 may encode and modulate a transmission bit stream to generate complex symbols. Further, upon receiving data, the communication unit 210 may demodulate and decode the baseband signal to reconstruct a received bit stream. In addition, the communication unit 210 may up-convert the baseband signal into a radio frequency (RF) band signal to transmit the RF band signal an the antenna, and down-convert the RF band signal received via the antenna into the baseband signal.

To this end, the communication unit 210 may include a transmission filter, a reception filter, an amplifier, a mixer, an oscillator, a digital-to-analog converter (DAC), an analog-to-digital converter (ADC), or the like. Further, the communication unit 210 may include a plurality of transmission/reception paths. Furthermore, the communication unit 210 may include at least one antenna array having a plurality of antenna elements. In terms of hardware, the communicator 210 may include a digital unit and an analog unit, in which the analog unit may include a plurality of sub-units depending on its operating power, operating frequency, and the like. Further, the communication unit 210 may include a decoding unit to perform decoding according to various embodiments of the disclosure.

The communication unit 210 serves to transmit and receive signals as described above. Accordingly, the communication unit 210 may be referred to as a "transmitter", a "receiver", or a "transceiver". Further, throughout the following description, transmission and reception performed over a wireless channel are used as meaning indicating that the above-described processing is performed by the communication unit 210. In addition, when the device of FIG. 2A is a base station, the communication unit 210 may further include a backhaul communication unit for communication with another network entity connected through a backhaul network.

The storage 220 may store data such as a basic program, an application program, setting information and the like for operating the reception node 120. The storage 220 may include a volatile memory, a non-volatile memory, or a combination of the volatile memory and the non-volatile memory. The storage 220 may provide the stored data according to a request of the controller 230.

The controller 230 may control the overall operations of the system. For example, the controller 230 may transmit and receive signals via the communication unit 210. Further, the controller 230 may record or read out data in the storage 220. To this end, the controller 230 may include at least one processor or a micro-processor, or may be a part of the processor. According to various embodiments, the controller 230 may control the system to perform operations according to various embodiments described below.

FIG. 2B is a diagram illustrating an example of a configuration of a transmitting device performing communications in a wireless communication system according to various embodiments of the disclosure.

Referring to FIG. 2B, the transmitting device 110 may include a communication unit 240, a storage 250, and a controller 260.

The communication unit 240 may perform functions for transmitting and receiving signals over a wireless channel. For example, the communication unit 240 may perform a conversion function between a baseband signal and a bit stream according to the physical layer specification of the system. For example, during data transmission, the communication unit 240 may generate complex symbols by encoding and modulating a transmission bit stream. Further, when receiving data, the communication unit 240 may reconstruct the received bit stream by demodulating and decoding the baseband signal. In addition, the communication unit 240 may up-convert the baseband signal into a radio frequency (RF) band signal to transmit the RF band signal via an antenna, and down-convert the RF band signal received via the antenna into the baseband signal.

To this end, the communication unit 240 may include a transmission filter, a reception filter, an amplifier, a mixer, an oscillator, a digital-to-analog converter (DAC), an analog-to-digital converter (ADC), and the like. In addition, the communication unit 240 may include a plurality of transmission/reception paths. Furthermore, the communication unit 240 may include at least one antenna array having a plurality of antenna elements. In terms of hardware, the communicator 240 may include a digital unit and an analog unit, and the analog unit may include a plurality of sub-units depending on its operating power, its operating frequency, and the like. Further, the communication unit 240 may include an encoding unit to perform encoding according to various embodiments of the disclosure.

The communication unit 240 serve to transmit and receive signals as described above. Accordingly, the communication unit 240 may be referred to as a "transmitter", a "receiver", or a "transceiver". In addition, throughout the following description, transmission and reception performed over a wireless channel are used as meaning to indicate that the above-described processing is performed by the communication unit 240. Further, when the device of FIG. 2B is a base station, the communication unit 240 may further include a backhaul communication unit for communication with another network entity connected through a backhaul network.

The storage 250 may store data such as a basic program, an application program, setting information or the like for operating the transmission node 110. The storage 250 may include a volatile memory, a non-volatile memory, or a combination of the volatile memory and the non-volatile memory. Further, the storage 250 may provide the stored data according to a request of the controller 260.

The controller 260 may control the overall operations of the system. For example, the controller 260 may transmit and receive a signal via the communication unit 240. Further, the controller 260 may record or read out data in the storage 250. To this end, the controller 260 may include at least one processor or a micro-processor, or may be a part of the processor. According to various embodiments, the controller 260 may control the system to perform operations according to various embodiments described below.

Hereinafter, various symbols or terms used in describing the disclosure in detail may be interpreted as commonly used mathematical symbols, unless explicitly defined otherwise. The LDPC code is a linear code and is generally defined by a parity-check matrix. Hereinafter, the number of information bits (also referred to as a code dimension) to be encoded using the LDPC code is referred to as *K* and the number of codeword bits (code length) resulting from encoding is referred to as *N*. The code rate is defined as *R=K/N*, and a value *N-K* obtained by subtracting the code dimension from the code length is referred to as the number of parity bits, the number of redundant bits. The information bit sequence of the length *K* to be encoded may be a codeword sequence encoded by outer coding such as a cyclic redundancy check (CRC) code or the like. When $\mathbb{F}_2 = \{0,1\}$ is taken to as a binary field, the codeword bit vector may be represented as $\mathbf{x} = (x_1, x_2, \ldots, x_N) \in \mathbb{F}_2^{1 \times N}$ (defined as a row vector). When the parity check matrix is given as $\mathbf{H} \in \mathbb{F}_2^{(N-K) \times N}$, the codeword bit vector may be generated to establish the relationship of the following equation.

[Equation 1]

$$(\text{pairty check equation}) \ \mathbf{H}\mathbf{x}^{\mathrm{T}} = \mathbf{0}$$

In the above Equation 1, $\mathbf{0} \in \mathbb{F}_2^{N-K}$ represents a zero vector. According to Equation 1, any codeword bit vector *x* of the LDPC code defined by the parity check matrix *H* is a null space for the parity check matrix *H*. Here, as the *j*-th row of *H* is denoted as $\mathbf{h}_j \in \mathbb{F}_2^{1 \times N}$ (row vector), the element of the *j*-th row of *H* and its *i*-th column is to be written as $h_{ji} \in \mathbb{F}_2$. The encoding and decoding of the LDPC code may be performed based on such a parity check matrix.

Now, a general decoding process of the LDPC code defined as the parity check matrix *H* will be described in detail with reference to some of the accompanying drawings. The decoding of the LDPC code may be understood as a message-passing, so-called a belief-propagation process, in which messages are repeatedly exchanged on a binary graph corresponding to the parity check matrix.

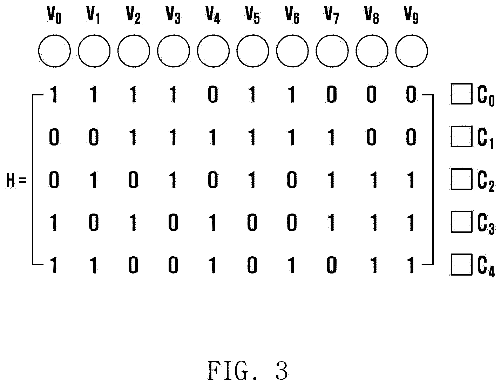

FIG. 3 is a diagram illustrating an embodiment of a parity check matrix of an LDPC code.

FIG. 3 shows an example of the parity check matrix $\mathbf{H} \in \mathbb{F}_2^{5 \times 10}$ of a binary LDPC code having the number of rows of *N-K*=5 and the number of columns of *N*=10. The number of 1 in the parity check matrix is referred to as density, which density determines the complexity of encoding and decoding. Since the density of a general parity check matrix of the LDPC code is very low compared to the dimension of the entire parity check matrix, it is called a low-density parity check code. It should be noted that the parity check matrix in Figure 3 is of an example for an illustration purpose only and is a matrix of a very small dimension, so the density is relatively high, and the parity check matrix with a larger dimension commonly used may have much lower density.

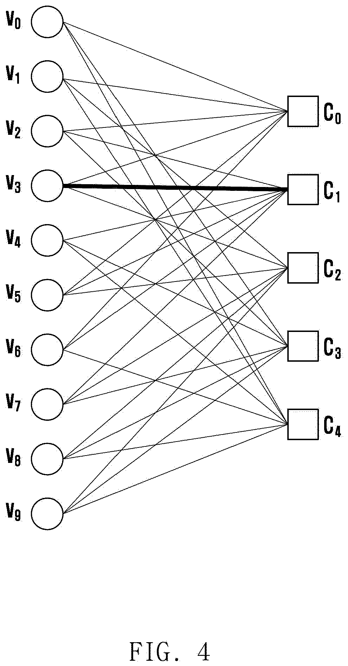

FIG. 4 is a diagram representing a binary graph corresponding to the parity check matrix of FIG. 3.

Referring to FIG. 4, the binary graph may comprise a set of variable nodes *v*(*v*|=*N*), a set of check nodes $\mathcal{C}$(|$\mathcal{C}$| = *N - K*), and a set (ε) of edges connecting elements of the two sets to each other. The variable nodes correspond to each bit of the codeword bit vector $\mathbf{x} \in \mathbb{F}_2^N$, wherein the *i*-th variable node represents *i*-th second codeword bit having the same index. The check node represents a linear equation indicated by the inner product on a binary field of each row of the parity check matrix *H* and the codeword bit vector *x*. In other words, the *j*-th check node represents a linear equation corresponding to $\mathbf{h}_j \mathbf{x}^{\mathrm{T}} = \sum_{i=1}^{N} h_{ji} x_i = 0$, which indicates that when a binary-sum (modulo-2 sum, bitwise XOR) is performed for bit values of all variable nodes connected to the *j*-th check node on the binary graph given by *H* are, its result is zero. The belief-propagation decoding of the LDPC code may be understood as an iterative message exchange process using the relationship between the variable node and the check node on the graph.

The LDPC code is being utilized in various communication and broadcasting systems, and is designed and used to satisfy the requirements demanded according to the characteristics of the systems.

The requirements of channel codes for communication systems include length-flexibility of code length. In a communication system, the amount of communication resources such as time, frequency or the like available for transmission of specific information may change every transmission for various reasons. For example, the total amount of available communication resources may change, or the amount of communication resources allocated to transmit the corresponding information from the total available communication resources may change. Since the number of bits capable of transmission changes at every time point of transmission, the channel code used for the communication system should be designed to flexibly change its code length.

Another required characteristic of channel coded for communication systems is rate-flexibility. In a communication system, particularly, a mobile communication system, the channel quality between the transmitter and receiver varies over time. For example, when the receiver is physically moving, the distance between the transmitter and receiver may change, resulting in different channel conditions such as e.g., path loss and multi-path fading. When the channel quality is good, the transmitter may increase the encoding rate (i.e., reduce the number of parity bits) to achieve error-free encryption/decryption with efficient utilization of communication resources. Conversely, when the channel is of poor quality, the transmitter may decrease the encoding rate (i.e., increase the number of parity bits) to increase the probability of overcoming the poor channel. Therefore, the channel coding used in communication systems should be designed to allow for flexible variation of the code rate.

Still another required characteristic of channel codes for communication systems is rate-compatibility. Communication systems should support data integrity while efficiently utilizing their communication resources, and generally utilize Hybrid Automatic Repeat and reQuest (HARQ) techniques to do so. Hereinafter, such a HARQ process will be briefly described. The transmitter encodes the information bit to be transmitted to create a codeword, and generates a signal through a processing such as modulation to transmit the signal to the receiver. The receiver attempts to decode the signal received from this first transmission (or initial transmission) by processing it through a series of processes. If the receiver detects an error through decoding of a CRC code and syndrome checking of an LDPC code, the receiver transmits the NACK to the transmitter to request retransmission. In this case, the receiver processes the received signal in a series of processes and then stores a log-likelihood ratio (LLR) sequence used for the decoding in a memory, a buffer, or the like. Here, the LLR is given as a value obtained by taking a logarithm to the ratio of the probability for the values 0 and 1 of each bit, and is used as a probability information metric for the corresponding bit. After receiving the NACK from the receiver, the transmitter generates a codeword for the existing information it wanted to transmit and transmits the codeword to the receiver. After the initial transmission, for example, the second transmission may be expressed as retransmission. The codeword generated for retransmission may be the same as the codeword transmitted in the initial transmission, and this HARQ scheme is referred to as Chase Combining HARQ (CC-HARQ). Conversely, in retransmission, the codeword may be generated and transmitted to include parity bits that were not sent during initial transmission, which is referred to as an Incremental Redundancy HARQ (IR-HARQ) scheme. Usually, the latter IR-HARQ method is used more frequently because it is more efficient. The receiver performs decoding by combining and utilizing the LLR sequence or the like stored in the initial transmission (although the decoding has failed) with the LLR sequence or the like newly obtained in the retransmission. If the decoding fails even in retransmission, a third transmission, a fourth transmission, and so on are sequentially performed in the same manner. The amount of communication resources assigned for each transmission may be different from each other. This process may be repeated up to a predetermined maximum number of retransmissions. As described above, the channel code for a communication system should be designed to allow decoding to be performed by combining two or more codewords generated to transmit the same information, that is, to have rate compatibility.

The LDPC code for a practical communication system is designed to have the above required characteristics (flexible code length, flexible code rate, and rate compatibility). Typically, in New Radio (NR), which is a 5th generation (5G) communication standard of 3GPP (3rd Generation Partnership Project), the LDPC code satisfying the aforementioned requirement characteristics is designed and in use. Hereinafter, the LDPC code of the NR system will be described as an example of the target system of the disclosure. However, it should be noted that the disclosure is not limited to such a system, and may be also applied to other various systems.

Many of the LDPC code systems actually used are designed with Quasi-Cyclic LDPC (QC-LDPC) codes that is suitable for implementation while satisfying the above required characteristic. The QC-LDPC codes belong to a structured LDPC coding class, and thus, they are widely used because they are easy to define the codes and are suitable for obtaining high throughput by decoding in a parallel architecture.

The QC-LDPC codes are defined from a small base matrix or a base graph (BG) in a one-to-one correspondence relationship with the base matrix, as shown in FIGS. 3 and 4. The base matrix and the base graph are treated as the same as each other. The base matrix may be written as $\mathbf{H}_p \in \mathbb{F}_2^{(n-k) \times n}$, wherein the number of rows of the base matrix is $n\text{-}k$ and the number of columns thereof is $n$. The parity check matrix $\mathbf{H} \in \mathbb{F}_2^{(N-K) \times N}$ to be finally obtained may be obtained by increasing the size of the base matrix $H_p$ through a copy-and-permute process. In particular, the copy-and-permute process of the QC-LDPC code is referred to as lifting, and the size used to increase $H_p$ to construct the parity check matrix $H$ is referred to as a lifting size. The lifting size is represented as Z. In other words, the size of the parity check matrix $H$ is Z times the size of the base matrix $H_p$. Specifically, $K=kZ$ and $N=nZ$.

The lifting process may be understood to replace each element of the base matrix with a square matrix $Z \times Z$. For this lifting process, an exponential matrix $\mathbf{E}_p \in \mathbb{Z}_Z^{(n-k) \times n}$ is defined, which is another matrix of the same size as the base matrix. Here, $\mathbb{Z}_z$ is a set of non-negative integers whose values are less than Z (i.e., $\mathbb{Z}_z = \{0, 1, \ldots, Z-1\}$). Each element of the base matrix is determined by its value and a value of the element at the same position as the exponential matrix. In the base matrix, an element having a value of 0 is substituted with a zero matrix having a size of $Z \times Z$ (i.e., a matrix having a value of 0 for all elements). In the base matrix, an element having a value of 1 is substituted with a circulant permutation matrix having the size of $Z \times Z$, wherein the circulant permutation matrix is a matrix obtained by circularly shifting an identity matrix having the same size $Z \times Z$ by a value recorded at the same position in the exponential matrix. By substituting each matrix of the base matrix with $Z \times Z$ matrix as described above, it is possible to obtain a parity check matrix whose total size is Z times larger.

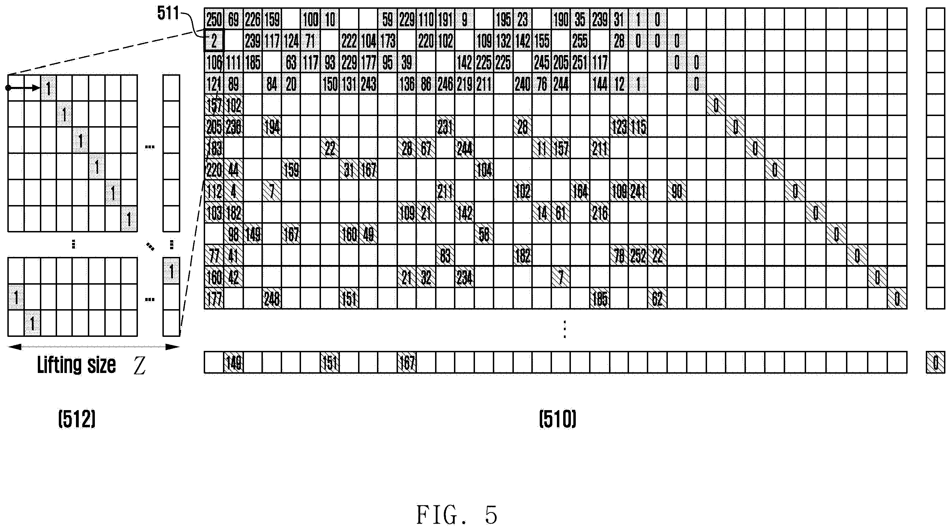

FIG. 5 is a diagram for use in understanding a lifting process, illustrating an example of a parity check matrix of a QC-LDPC code. A reference numeral 510 shown in FIG. 5 represents a parity check matrix $H$ by displaying an exponential matrix $E_p$ on a base matrix $H_p$. That is, the value described at each position of the matrix of 510 represents a circular shift value of each circulant permutation matrix indicated by the exponential matrix $E_p$. Specifically, the portion where no value is indicated at each position is a portion where the element is 0 in the corresponding base matrix $H_p$, and becomes $Z \times Z$ zero matrix as described above. The portion where a value is indicated at each position is $Z \times Z$ circulant permutation matrix, and its circular shift value is determined by the value indicated at each position. For example, a reference numeral 511 is an element having a value of 2, and this portion actually represents $Z \times Z$ circulant permutation matrix 512 having a circular shift value of 2.

The QC-LDPC code configured as described above adjusts the code dimension and length by adjusting the lifting size Z value. As described above, the code dimension and length of the base matrix $H_p$ are k and n, respectively. The parity check matrix $H$ finally obtained based on the above becomes $K=kZ$ and $N=nZ$, of which code dimension and length are Z times larger, respectively. Therefore, if Z is small, the code dimension and length of the finally obtained parity check matrix $H$ are small. On the other hand, if Z is large, the code dimension and length of the finally obtained parity check matrix are large. The parity check matrices of various code dimensions and lengths may be defined by adjusting the Z value based on these characteristics.

For example, the 3GPP NR LDPC code system defines two base graphs, BG1 and BG2, and lifts these two base graphs to various sizes to obtain a parity check matrix. BG1 is used to support a situation in which the code dimension and length are relatively large and the code rate is high, and BG2 is used to support situations in which the code dimension and length are relatively small and the code rate is low. The code dimension and length of BG1 are given as k=22 and n=68, respectively. The code dimension and length of BG 2 are given as k=10 and n=52, respectively. For each BG, a total of 51 cases of lifting size Z are defined from 2 to 384. Therefore, the parity check matrix $H$ obtained from BG1 may support the code dimension $K=kZ$ ranging from $22 \times 2=44$ to $22 \times 384=8448$ in a single code block. Further, the parity check matrix $H$ obtained from BG2 may support the code dimension $K=kZ$ ranging from $10 \times 2=20$ to $10 \times 384=3840$ in a single code block.

The decoder of the QC-LDPC code may basically perform operations in Z-bit units. The decoding operation of the LDPC code is based on the parity check matrix $H$, and $H$ is made up of circulant permutation matrices having the size of $Z \times Z$, as described above. In a circulant permutation matrix, there is only one non-zero element in a particular row, and likewise, there is only one non-zero element in a particular column. Based on these characteristics, a variable node and a check node for each circulant permutation matrix may perform completely independent operations independently of each other without any conflict. In other words, the Z variable nodes and the Z check nodes making up the circulant permutation matrix may perform their operations independently of each other, and thus may be fully parallelized. For this reason, the decoder for the QC-LDPC code is usually configured of the form to process each $Z \times Z$ circulant permutation matrix unit, or to process units of Z rows (i.e., submatrix of a size $Z \times N$) of the parity check matrix. Here, a decoding scheduling scheme for sequentially processing units of Z rows (i.e., submatrix of size $Z \times N$) is referred to as a layered decoding. Such a layered decoding scheme is widely used as a practical decoding scheme for decoding QC-LDPC codes.

Now, when HARQ operation occurs, the problem that may occur in the conventional QC-LDPC decoder as described above will be discussed and an embodiment of the disclosure for addressing such a problem will be described. The transmitter generates a codeword bit sequence of length E suitable for a given transmission resource, from a codeword generated by a mother QC-LDPC code of code length N for each transmission. In this way, this process of generating a codeword sequence by adjusting the code rate to be suitable for the transmission resource from the codeword of the mother code is referred to as rate-matching. This operation is usually carried out based on a virtual circular buffer and is referred to as circular-buffer rate-matching. In summary, the symbol N represents a length of the mother code used, and the symbol E represents the rate-matching output size transmitted and received. The rate-matching output length E is determined by the communication resource given for each transmission, and repetition of the codeword bit of the mother code occurs when E is greater than N, and puncturing of the codeword bit of the mother code occurs when E is less than N.

When retransmission is performed by HARQ, an exceptional situation that generally does not occur in the initial transmission may occur. In the channel code, the transmission code rate is defined as $R=K/E$ which should be determined by the quality of the channel to which the codeword is to be transmitted, but should be less than or equal to 1. In other words, the number of bits of the transmitted codeword, i.e., the code length E, should be greater than or equal to the code dimension K. Otherwise, in other words, when the transmitted/received code length E is less than the code dimension K, the decoder may be unable to obtain any information about K-E non-transmitted information bits, and thus, it may be unable to perform normal decoding. On the other hand, since the previously transmitted codeword is already used in retransmission and subsequent transmission, there is no restriction on the length of the transmitted code. Because of this issue, a problem may occur after retransmission, in case where the decoder is configured in consideration of only the situation of initial transmission.

More specifically, the code length transmitted in $i$-th transmission is denoted by $E_i$. As described above, in order to have at least a possibility of successful decoding in the first transmission ($i=1$), the condition of $E_1{\geq}K$ should be satisfied. When the decoding in the initial transmission fails and the retransmission occurs ($i=2$), the length of the entire code used by the decoder becomes $E_1+E_2$, and the condition of $E_1+E_2{\geq}K$ should be satisfied for the decoding to be successful. In this case, since the condition of $E1{\geq}K$ has been already satisfied at the initial transmission, only the condition of $E_2{\geq}O$ needs to be satisfied for $E_2$, and if the transmission has been already made, there may be no special restrictions for $E_2$ because it is at least $E_2>O$. This condition may be also equally established for the third and subsequent transmissions ($i=3,4,...$). In summary, the condition of $E_1{\geq}K$ should be satisfied in order for the possibility of decryption success not to be zero at least for each transmission, and only the condition of $E_i>O$ is required for the transmissions ($i=2,3,...$). That is, the code length transmitted after the retransmission may be an arbitrary length greater than 0. In an extreme case, it may be as small as 1 bit. If the code length becomes smaller after the retransmission, it is because the amount of communication resources allocated for the codeword transmission has been reduced compared to the initial transmission. In fact, the total amount of physical communication resources may have decreased, or although the total amount of communication resources may not have decreased, the amount of resources allocated for the corresponding codeword transmission may have decreased due to transmission of other information.

In the initial transmission, the condition of $E_1{\geq}K$ is satisfied, $K=kZ$, and k is a positive integer, so the condition $E_1{\geq}Z$ holds. However, there are no special restrictions in the retransmission, so it may be $E_i<Z$ in case where $i$ is greater than or equal to 2. In this case, a critical problem may occur in the decoder structure for the QC-LDPC code described above. As noted above, the decoder of the QC-LDPC code may have a minimum operating unit of Z bits for an effective operation. Owing to the configuration of the consistent decoder as well as the decoding operation, its related peripheral operation may also be configured in Z-bit units. Such peripheral operations may include bit deinterleaving, inverse rate matching (also referred to as de-rate matching or rate dematching), LLR combining for HARQ operation or the like. These operations may operate in an operating unit of a minimum Z-bit, and if a length of the LLR sequence for the codeword is less than Z, a normal operation may not be performed.

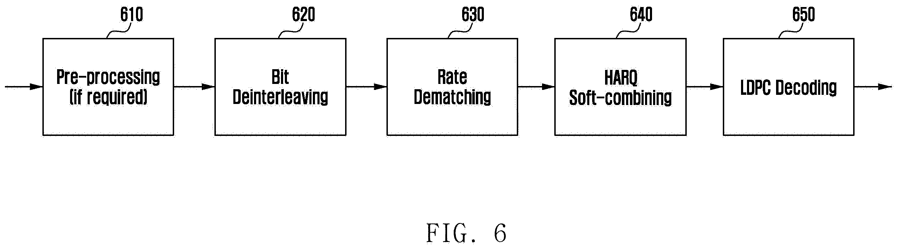

To address such a problem, an embodiment of the disclosure proposes a method of identifying a condition related to a code length and a minimum operating unit, and readjusting an input LLR sequence according to a procedure based on the condition or generating a new input LLR sequence. Hereinafter, an embodiment of the disclosure will be described in detail with reference to FIG. 6.

The decoder according to an embodiment of the disclosure identifies a code parameter (code dimension K, mother code length N, transmission codeword length E, modulation order $Q_m$) for a codeword transmitted by the transmitter. Here, the modulation order is a value determined by the modulation scheme in use, and it is 1 for the binary phase shift keying (BPSK), 2 for the quadrature phase shift keying (QPSK), and a value determined by $\log_2 M$ for the quadrature amplitude modulation (M-ary QAM). The sequence input by the input of the decoder may be expressed as LLR sequence $\Phi = (\phi_0, \phi_1, ... , \phi_{E-1})$, and the length of this sequence is the same as the transmission codeword length E. Here, it is assumed that the index of the elements of the sequence is determined using zero-based numbering. The decoder may configure or determine the parity check matrix of the QC-LDPC code to be used for decoding based on the identified code parameters. In this case, the decoder identifies a unit B operating the decoder, and this value in the decoder for the QC-LDPC code is usually related to the lifting size Z value. That is, the operating unit B of the decoder may be the same as Z or may be determined based on Z. For example, the operating unit (e.g., A=32) for any positive integer A may be determined as $B=\max(A,Z)$. Here, A may be a minimum operating unit determined based on the characteristics of the decoder. As a result, it should be noted that the default operating unit B may be determined differently by the configuration of the decoder.

The decoder configured according to an embodiment of the disclosure may compare the operating unit B with a value of the length E of the LLR sequence to be processed. If the length E of the transmission codeword is less than the operating unit B (i.e., *E<B*), then the decoder may generate (610) a modified LLR sequence

$$\Phi' = (\phi'_0, \phi'_1, \dots, \phi'_{E'-1})$$ by processing the LLR sequence in a series of processes to prevent a potential or explicit malfunction, and may perform a series of operations for LDPC decoding based on the generated LLR sequence. These series of operations may include bit deinterleaving (620), rate dematching (630), HARQ soft-combining (640), and LDPC decoding (650). Some of these operations may not be included or may not be performed depending on the configuration and requirements of the system and the transmission situation thereof. The length E' of the modified LLR sequence may be simply determined as B, or may be determined to be greater than or equal to B depending on the configuration of the subsequent operation. For example, when the subsequent operation includes bit deinterleaving based on the modulation order $Q_m$, the length E' of the modified LLR sequence may be determined to be a multiple of the modulation order $Q_m$ while being greater than or equal to the operating unit B. Since it is advantageous in terms of complexity that the length E' of the modified LLR sequence to be processed by the decoder is as small as possible, it may be determined, for example, using the following equation.

**[Equation 2]**

$$E' = \lceil B/Q_m \rceil \times Q_m$$

According to the above equation, E' is a multiple of the smallest $Q_m$ that is greater than or equal to B.

If the length E of the transmission codeword is greater than or equal to the operating unit B (i.e., *E≥B*), then the decoder may perform a series of operations for the LDPC decoding based on the input LLR sequence $\Phi = (\phi_0, \phi_1, \dots, \phi_{E-1})$.

Hereinafter, it will be described a series of operations of generating a modified LLR sequence Φ' when the length E of the transmission codeword is less than the operating unit B. According to an embodiment of the disclosure, in case where the input LLR sequence does not need to be bit de-interleaved, the modified LLR sequence Φ' may be generated by appending E'-E LLR 0s after Φ of the length E. In other words, the modified LLR sequence may be generated

as $$\Phi' = (\phi'_0, \phi'_1, \dots, \phi'_{E'-1}) = (\phi_0, \phi_1, \dots, \phi_{E-1}, 0, \dots, 0)$$ . The decoder may perform the decoding based on the modified LLR sequence Φ', assuming that the length of the input LLR sequence is E'.

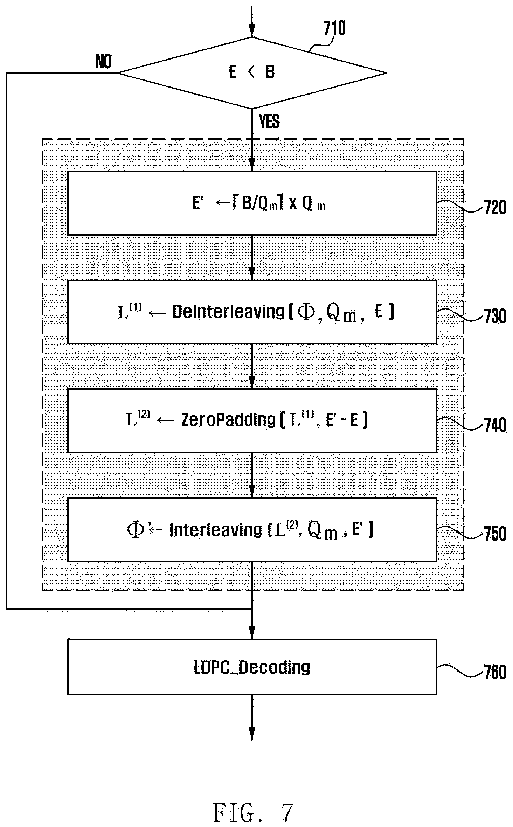

In case where the input LLR sequence needs to be bit de-interleaved, it is possible to generate Φ' by performing a series of processes of (de-interleaving)-(LLR 0 padding)-(interleaving) to Φ, as shown in the sequence diagram of FIG. 7.

FIG. 7 is a sequence diagram illustrating a process of performing decoding after a series of pre-processing according to an embodiment of the disclosure. Hereinafter, the series of processes will be described by taking a bit interleaving operation performed in a 5G NR system as an example.

Referring to FIG. 7, when the length E of the transmission codeword is less than the operating unit B (710), the length E' of the modified LLR sequence may be determined using Equation 2 (720). The decoder may generate a

temporary LLR sequence $$\mathcal{L}^{(1)} = \left(L_0^{(1)}, L_1^{(1)}, \dots, L_{E-1}^{(1)}\right)$$ having the same length E by deinterleaving $\Phi = (\phi_0, \phi_1, \dots, \phi_{E-1})$ on a virtual rectangular buffer having a row size of $Q_m$ and a column size of $E/Q_m$ (730). The deinterleaving operation may be performed to obtain a result as described in the following pseudo-code.

```
for j = 0 to E/Q_m − 1

    for i = 0 to Q_m − 1

        L^{(1)}_{i·E/Q_m+j} ← ϕ_{i+j·Q_m}

    end for

end for
```

$$\mathcal{L}^{(1)} = \left( L_0^{(1)}, L_1^{(1)}, \ldots, L_{E-1}^{(1)} \right)$$

When the LLR sequence $\mathcal{L}^{(1)} = \left( L_0^{(1)}, L_1^{(1)}, \ldots, L_{E-1}^{(1)} \right)$ having the same length E is obtained by performing deinterleaving as described above, the decoder may generate a new temporary LLR sequence

$$\mathcal{L}^{(2)} = \left( L_0^{(2)}, L_1^{(2)}, \ldots, L_{E'-1}^{(2)} \right) = \left( L_0^{(1)}, L_1^{(1)}, \ldots, L_{E-1}^{(1)}, 0, 0, \ldots, 0 \right)$$

having a length E' by performing a zero LLR padding (or zero LLR appending) operation to add E'-E LLR 0s after the LLR sequence (740). The decoder may generate

$$\Phi' = \left( \phi_0', \phi_1', \ldots, \phi_{E'-1}' \right)$$

the finally modified LLR sequence $\Phi' = \left( \phi_0', \phi_1', \ldots, \phi_{E'-1}' \right)$ by performing interleaving on the obtained LLR sequence $\mathcal{L}^{(2)}$ (750). The interleaving operation may be performed to obtain a result as described in the following pseudo-code.

```
for j = 0 to E'/Q_m − 1

    for i = 0 to Q_m − 1

        ϕ'_{i+j·Q_m} ← L^{(2)}_{i·E'/Q_m+j}

    end for

end for
```

When the modified LLR sequence Φ' as described is obtained, the decoder may perform decoding based on the same. The decoder may set the length of the input LLR sequence as E' and perform decoding using the modified

LLR sequence $\Phi' = \left( \phi_0', \phi_1', \ldots, \phi_{E'-1}' \right)$ as an input (760).

Hereinafter, the above processes are described by way of example. Suppose that the lifting size Z determined by the code parameter of the initial transmission is 64, and the length E of the codeword transmitted in the retransmission is 36 bits. 64QAM was used as the modulation technique, and $Q_m$ is 6. Suppose that the operating unit B was determined to be 64, and accordingly, the length E' of the modified LLR sequence accordingly was determined to be

$$E' = \lceil 64/6 \rceil \times 6 = 66$$

through Equation 2. The initially allocated LLR sequence is $\Phi = (\phi_0, \phi_1, \ldots, \phi_{35})$. This LLR sequence may be deinterleaved like the pseudo-code based on a rectangular buffer having the number of rows of $Q_m=6$ and the number of columns of $E/Q_m=6$. This deinterleaving operation may be also understood as a process of writing an LLR sequence in the allocated rectangular buffer by each column and reading the same by each row. The LLR index of the LLR sequence Φ written from each column in the rectangular buffer is given as shown in the table below.

| 0 | 6 | 12 | 18 | 24 | 30 |
|---|---|----|----|----|----|
| 1 | 7 | 13 | 19 | 25 | 31 |

(continued)

| 2 | 8 | 14 | 20 | 26 | 32 |
|---|---|----|----|----|----|
| 3 | 9 | 15 | 21 | 27 | 33 |
| 4 | 10 | 16 | 22 | 28 | 34 |
| 5 | 11 | 17 | 23 | 29 | 35 |

When reading the rectangular buffer as in the table above from each row, it may generate $\mathcal{L}^{(1)}$ as follows:

$$\mathcal{L}^{(1)} = (\phi_0, \phi_6, \phi_{12}, \phi_{18}, \phi_{24}, \phi_{30}, \phi_1, \phi_7, \phi_{13}, \phi_{19}, \phi_{25}, \phi_{31}, \dots, \phi_5, \phi_{11}, \phi_{17}, \phi_{23}, \phi_{29}, \phi_{35})$$

And, adding E'-E=66-36=30 LLR 0s to $\mathcal{L}^{(1)}$ produces $\mathcal{L}^{(2)}$ as follows:

$$\mathcal{L}^{(2)} = (\phi_0, \phi_6, \phi_{12}, \phi_{18}, \phi_{24}, \phi_{30}, \dots, \phi_5, \phi_{11}, \phi_{17}, \phi_{23}, \phi_{29}, \phi_{35}, 0,0,0, \dots, 0)$$

The LLR sequence $\mathcal{L}^{(2)}$ is interleaved as the pseudo-code based on the rectangular buffer having the number of rows of $Q_m$=6 and the number of columns of $E'/Q_m$=11. This interleaving operation may be understood as a process of writing the LLR sequence in a given rectangular buffer from each row and reading the LLR sequence by each column.

The index of the LLR in which the LLR sequence $\mathcal{L}^{(2)}$ is written from each row in the rectangular buffer is given as shown in the table below, where -1 represents the position where the LLR 0 is mapped.

| 0 | 6 | 12 | 18 | 24 | 30 | 1 | 7 | 13 | 19 | 25 |
|----|----|----|----|----|----|----|----|----|----|----|
| 31 | 2 | 8 | 14 | 20 | 26 | 32 | 3 | 9 | 15 | 21 |
| 27 | 33 | 4 | 10 | 16 | 22 | 28 | 34 | 5 | 11 | 17 |
| 23 | 20 | 35 | -1 | -1 | -1 | -1 | -1 | -1 | -1 | -1 |
| -1 | -1 | -1 | -1 | -1 | -1 | -1 | -1 | -1 | -1 | -1 |
| -1 | -1 | -1 | -1 | -1 | -1 | -1 | -1 | -1 | -1 | -1 |

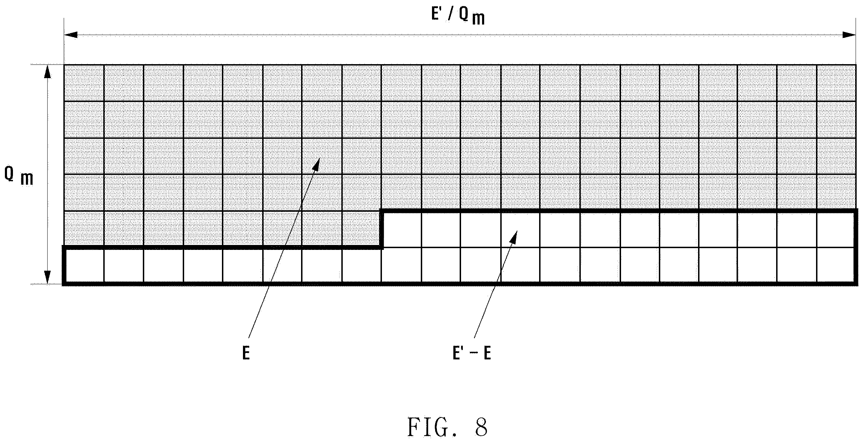

The above buffer shape is also shown in FIG. 8. The modified LLR sequence finally input to the decoder using the above process is given as follows:

$$\Phi' = (\phi_0, \phi_{31}, \phi_{27}, \phi_{23}, 0, 0, \phi_6, \phi_2, \phi_{33}, \phi_{29}, 0,0, \dots, \phi_{25}, \phi_{21}, \phi_{17}, 0,0,0)$$

In performing the above operation, the length E' of the finally modified LLR sequence may be determined by the operating unit B (which may be determined by the lifting size Z), the length E of the input LLR sequence, the modulation order $Q_m$, or the like.

Alternatively, for simpler operation, the decoder may not determine the value of E' using Equation 2, but may use a predetermined constant that is always the same value. As described above, since E' should be a multiple of the modulation order $Q_m$, it may be determined as a common multiple of all modulation orders used in the communication system to be applied. For example, the modulation orders 1, 2, 4, 6, and 8 are considered in a 5G NR system, and thus, a multiple of 24, which is a least common multiple, may be fixed and used as E'. In particular, when E' is determined to be greater than or equal to 384 considering the maximum lifting size 384 of the NR system, E' may be determined to be 384. Alternatively, if it is used up to 1024-QAM and the modulation order of 10 is additionally considered, E' may be determined as 480 in the same way. With this fixed value of E', the interleaving operation may be always performed consistently for the same length.

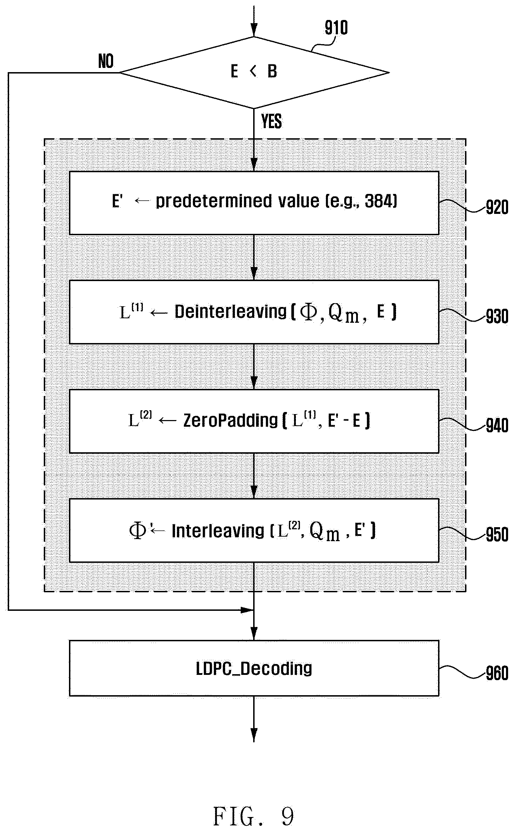

FIG. 9 is a sequence diagram illustrating a process of performing a series of pre-processing and then decoding based on a predetermined length according to an embodiment of the disclosure.

Referring to FIG. 9, when the length E of the transmission codeword is less than the operating unit B (910), the decoder may determine the length E' of the modified LLR sequence with a preset value according to the foregoing

$$\mathcal{L}^{(1)} = \left( L_0^{(1)}, L_1^{(1)}, \dots, L_{E-1}^{(1)} \right)$$

(920). The decoder may generate a temporary LLR sequence of the same length E by deinterleaving $\Phi = (\phi_0, \phi_1, \dots, \phi_{E-1})$ on a virtual rectangular buffer having a row size of $Q_m$ and a column size $E/Q_m$ (930). Since the deinterleaving operation has been described above with reference to FIG. 7, its detailed description will be omitted.

$$\mathcal{L}^{(1)} = \left( L_0^{(1)}, L_1^{(1)}, \dots, L_{E-1}^{(1)} \right)$$

When the LLR sequence of the same length E is obtained by performing deinterleaving as described above, the decoder may generate a new temporary LLR sequence

$$\mathcal{L}^{(2)} = \left( L_0^{(2)}, L_1^{(2)}, \dots, L_{E'-1}^{(2)} \right) = \left( L_0^{(1)}, L_1^{(1)}, \dots, L_{E-1}^{(1)}, 0, 0, \dots, 0 \right)$$

of a preset length E' by performing a zero LLR padding (or zero LLR appending) operation adding E'-E LLR 0s after this LLR sequence $\mathcal{L}^{(1)}$ (940). The decoder

$$\mathbf{\Phi}' = \left( \phi_0', \phi_1', \dots, \phi_{E'-1}' \right)$$

may generate the finally modified LLR sequence by performing the interleaving on the LLR sequence $\mathcal{L}^{(2)}$ so obtained (950). Since the interleaving operation has been described above with reference to FIG. 7, its detailed description will be omitted.

When the modified LLR sequence $\Phi'$ as described above is obtained, the decoder may perform decoding based on the modified LLR sequence. The decoder may set the length of the input LLR sequence as E' and perform the

$$\mathbf{\Phi}' = \left( \phi_0', \phi_1', \dots, \phi_{E'-1}' \right)$$

decoding, taking the modified LLR sequence as an input (960).

A similar problem may also occur in the encoder of the transmitter when the length of the sequence to be processed as in the decoder is less than the operating unit. For example, the number of bits, E, transmitted by rate-matching of the encoder may be less than the operating unit B of the encoder, and the encoder may not perform a normal operation due to an explicit or implied reason. This problem may usually occur in an LDPC encoder having a hardware-fixed structure. This circumstance may generally occur after retransmission according to the HARQ operation. For convenience of description, the operating unit B is denoted by the same symbol, but the operating unit of the decoder and the operating unit of the encoder described above may be the same as or different from each other.

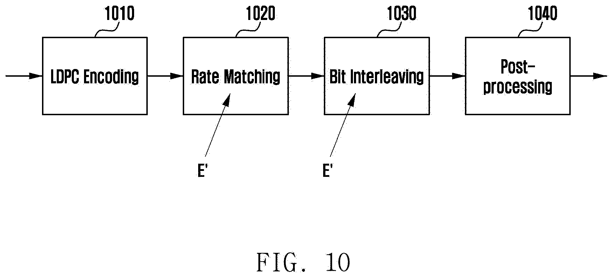

FIG. 10 is a diagram illustrating a process of performing encoding including post-processing according to conditions in an embodiment of the disclosure.

The encoder according to an embodiment of the disclosure may operate as shown in a block diagram of FIG. 10 in a situation where the number of bits, E, transmitted is less than the operating unit B of the encoder, as described above. Referring to FIG. 10, the encoder may first generate a mother codeword bit sequence $\mathbf{d} = (d_0, d_1, \dots, d_{N-1})$ of a length N by performing LDPC encoding (1010) based on a mother code in use. As described above, the encoder having the constraint according to the operating length may not operate normally in case where a rate-matching output length E is less than the operating unit B. Accordingly, when the rate-matching output length E determined by the transmission resource is less than the operating unit B of the encoder, the encoder may determine the modified rate-matching output length E' to be greater than or equal to B and perform subsequent processes. When bit interleaving is performed based on the modulation order $Q_m$ in the subsequent process, E' should be determined as a multiple of $Q_m$ and may be determined as in Equation 2. Alternatively, for consistent operation, it may always be determined as the same value regardless of the operating unit B, and for example, it may be determined as a common multiple (e.g. 384 or 480) of all modulation orders $Q_m$ used in the system.

When E' is determined as described above, the encoder may obtain a rate-matching bit sequence $\mathbf{e}' = (e_0, e_1, \dots, e_{E'-1})$ by performing a rate-matching based on the modified rate-matching output length E' (1020). In addition, the encoder may perform bit interleaving this rate-matching bit sequence based on a rectangular matrix of $Q_m$ rows and

$E'/Q_m$ columns according to the above-described method to obtain a bit sequence $\mathbf{f}' = \left( f_0', f_1', \dots, f_{E'-1}' \right)$ of the same length (1030). It is to be noted that such rate-matching and bit interleaving are performed based on the modified rate-matching output length E' rather than the rate-matching output length E initially determined by the transmission resource. After going through this series of processes, the transmitter may perform post processing to generate a bit sequence **f** = ($f_0$, $f_1$, ... , $f_{E-1}$) of length E actually specified (1040).

The subsequent processing is carried out according to the following procedures. If the bit interleaving operation is not performed after LDPC encoding, the encoder may obtain **f** = ($f_0$, $f_1$, ... , $f_{E-1}$) by discarding, that is, puncturing, E'-

$$\mathbf{f}' = \left( f'_0, f'_1, \dots, f'_{E'-1} \right)$$

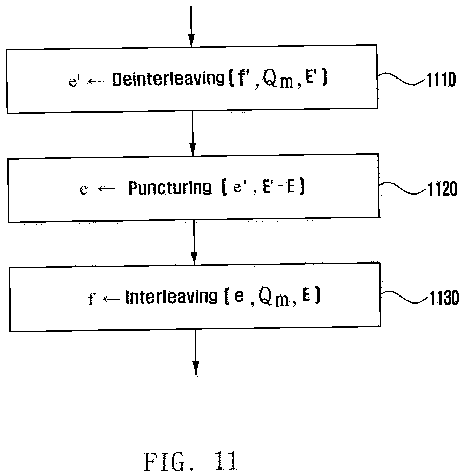

E bits located behind in ⬚. If the bit interleaving operation is performed after the LDPC encoding, the encoder performs a series of processes shown in FIG. 11.

FIG. 11 is a diagram illustrating an example of a process of a post-processing operation according to an embodiment of the disclosure.

Referring to FIG. 11, the encoder may first perform deinterleaving on f to again obtain **e'** = ($e_0$, $e_1$, ... , $e_{E'-1}$) (1110). This deinterleaving operation may be performed to obtain the same result as the following pseudo-code.

```
for j = 0 to E/Q_m − 1
    for i = 0 to Q_m − 1
        e'_{i·E/Q_m+j} ← f_{i+j·Q_m}
    end for
end for
```

When the bit sequence **e'** = ($e_0$, $e_1$, ... , $e_{E'-1}$) is obtained as described above, the encoder may obtain the bit sequence **e** = ($e_0$, $e_1$, ... , $e_{E-1}$) by discarding, that is, puncturing, the E'-E bits located behind (1120). The encoder may obtain a final transmission codeword **f** = ($f_0$, $f_1$, ... , $f_{E-1}$) by bit interleaving the bit sequence **e** = ($e_0$, $e_1$, ... , $e_{E-1}$) with respect to the length E again (1130). This bit interleaving operation may be performed to obtain the same result as the following pseudo-code.

```
for j = 0 to E'/Q_m − 1
    for i = 0 to Q_m − 1
        f_{i+j·Q_m} ← e_{i·E'/Q_m+j}
    end for
end for
```

A method for processing a signal encoded by LDPC coding, in an HARQ operation, according to an embodiment of the disclosure based on the foregoing description may comprise the steps of receiving a transmitted signal; identifying a code parameter applied by initial transmission of the HARQ operation and determining a configuration of a decoder; generating a first sequence of an LDPC code decoder of an LLR or the like from the received signal based on the configuration; comparing a length of the first sequence with an operating unit of the configured LDPC code decoder; when the length of the first sequence is less than the operating unit, generating a second sequence based on the first sequence; and decoding the LDPC code based on the second sequence.

According to an embodiment, the length of the second sequence may be at least equal to or greater than the operating unit determined by the configuration of the LDPC code decoder.

According to an embodiment, the operating unit determined by the configuration of the LDPC code decoder may be determined based on a lifting size of the decoder.

According to an embodiment, the second sequence may be obtained by appending an element having a value of 0 to the first sequence.

According to an embodiment, the second sequence may be obtained by performing first interleaving onto the first sequence, appending thereto the element having a value of 0, and performing second interleaving thereon.

According to an embodiment, the first interleaving and the second interleaving are for sequences having different lengths, but their operations may be defined as an inverse relationship. For example, the first interleaving and the second interleaving may be defined as deinterleaving and interleaving operations as described above, respectively.

The methods according to various embodiments described in the claims and/or specification of the disclosure may be implemented in hardware, software, or a combination of hardware and software.

When implemented as software, a computer-readable storage medium or a computer program product storing one or more programs (software modules) may be provided. The one or more programs stored in the computer-readable storage medium or the computer program product are configured for execution by one or more processors in an electronic device. The one or more programs include instructions that cause the electronic device to execute methods according to embodiments described in the specification or claims of the disclosure.

These programs (software modules or software) may be stored in a random access memory, a non-volatile memory including a flash memory, a read only memory (ROM), an electrically erasable programmable read only memory (EEPROM), a magnetic disc storage device, a compact disc ROM (CD-ROM), digital versatile discs (DVDs), other types of optical storage devices, magnetic cassettes, or the like. Alternatively, it may be stored in a memory configured by a combination of some or all of those. In addition, a plurality of respective constituent memories may be included.

Further, the program may be stored in an attachable storage device that is accessible via a communication network such as e.g., Internet, Intranet, a local area network (LAN), a wide LAN (WLAN), or a storage area network (SAN), or a communication network configured with a combination of those. Such a storage device may access a device performing an embodiment of the disclosure via an external port. In addition, a separate storage device on a communication network may access the device performing embodiments of the disclosure.

In the above-described specific embodiments of the disclosure, an element included in the disclosure is expressed in a singular or plural form depending on a presented specific embodiment. However, the singular form or plural form is selected to suit its presented situation for the convenience of description, and the disclosure is not limited to the singular element or the plural element presented, and either a component expressed in plural may be configured in a singular form, or a component expressed in singular may be configured in a plural form.

Meanwhile, the embodiments of the disclosure disclosed in the specification and drawings are merely certain examples presented to easily describe the technical contents of the disclosure and help understanding of the disclosure, and are not intended to limit the scope of the disclosure thereto. That is, it is obvious to those skilled in the art to which the disclosure pertains that other modified examples based on the technical idea of the disclosure may be implemented. Each of the embodiments may be operated in combination with each other as necessary. For example, a base station and a terminal may be operated by combining parts of an embodiment of the disclosure and parts of another embodiment of the disclosure. The embodiments of the disclosure may also be applied to other communication systems, and other modifications based on the technical idea of the embodiments may also be implemented. For example, the embodiments may also be applied to an LTE system, a 5G system, or an NR system.

**Claims**

1. A method performed by a receiving device of a communication system, comprising:

   obtaining a first sequence based on a received signal;
   comparing a length of the first sequence with an operating unit;
   when the length of the first sequence is less than the operating unit, generating a second sequence based on the first sequence; and
   performing decoding based on the second sequence,
   wherein the length of the second sequence is greater than or equal to the operating unit.

2. The method of claim 1, wherein the operating unit is determined based on a lifting size.

3. The method of claim 1, wherein the length of the second sequence is a multiple of a modulation order, being greater than or equal to the operating unit.

4. The method of claim 1,

   wherein the second sequence is generated to further include a predetermined number of elements having a value of 0 in elements of the first sequence, and
   wherein the predetermined number is a difference between the length of the second sequence and the length of the first sequence.

5. The method of claim 1, wherein the generating the second sequence comprises:

generating a third sequence by performing deinterleaving based on the first sequence;
generating a fourth sequence by adding the predetermined number of elements having a value of 0 to the third sequence; and
generating the second sequence by performing interleaving based on the fourth sequence.

6.  A receiving device of a communication system, comprising:

    a transceiver; and
    a controller configured to:

    obtain a first sequence based on a received signal;
    compare a length of the first sequence with an operating unit;
    when the length of the first sequence is less than the operating unit, generate a second sequence based on the first sequence; and
    perform decoding based on the second sequence,

    wherein the length of the second sequence is greater than or equal to the operating unit.

7.  The receiving device of claim 6, wherein the operating unit is determined based on a lifting size.

8.  The receiving device of claim 6, wherein the length of the second sequence is a multiple of a modulation order, being greater than or equal to the operating unit.

9.  The receiving device of claim 6,

    wherein the second sequence is generated to further include a predetermined number of elements having a value of 0 in elements of the first sequence, and
    wherein the predetermined number is a difference between the length of the second sequence and the length of the first sequence.

10. The receiving device of claim 9, wherein the controller is further configured to:

    generate a third sequence by performing deinterleaving based on the first sequence;
    generate a fourth sequence by adding the predetermined number of elements having a value of 0 to the third sequence; and
    generate the second sequence by performing interleaving based on the fourth sequence.

11. A method performed by a transmitting device of a communication system, comprising:

    identifying a length of a bit sequence for performing transmission;
    comparing the length of the bit sequence for performing the transmission with an operating unit;
    when the length of the bit sequence for performing the transmission is less than the operating unit, generating a second bit sequence having a length greater than or equal to the operating unit;
    generating a first bit sequence having the length of the bit sequence for performing the transmission, based on the second bit sequence; and
    transmitting a signal based on the first bit sequence.

12. The method of claim 11, wherein the generating the second bit sequence comprises:

    performing rate-matching based on the length of the second bit sequence; and
    performing bit interleaving based on the length of the second bit sequence.

13. The method of claim 11, wherein the length of the second bit sequence is a multiple of a modulation order, being greater than or equal to the operating unit.

14. The method of claim 11,

    wherein the first bit sequence is generated by puncturing a predetermined number of bits in elements of the second bit sequence;

wherein the predetermined number is a difference between a length of the second bit sequence and a length of the first bit sequence; and

wherein the generating the first bit sequence comprises:

generating a third bit sequence by performing deinterleaving based on the second bit sequence;
generating a fourth bit sequence by puncturing the predetermined number of bits in the third bit sequence; and
generating the first bit sequence by performing interleaving based on the fourth bit sequence.

15. A transmitting device of a communication system, comprising:

a transceiver; and
a controller configured to:

identify a length of a bit sequence for performing transmission;
compare the length of the bit sequence for performing the transmission with an operating unit;
when the length of the bit sequence for performing the transmission is less than the operating unit, generate a second bit sequence having a length greater than or equal to the operating unit;
generate a first bit sequence having the length of the bit sequence for performing the transmission, based on the second bit sequence; and
transmit a signal based on the first bit sequence.

110

120

TRANSMISSION NODE → RECEPTION NODE

FIG. 1

RECEPTION NODE (120)

FIG. 2A

TRANSMISSION NODE (110)

FIG. 2B

$$H = \begin{bmatrix} 1 & 1 & 1 & 1 & 0 & 1 & 1 & 0 & 0 & 0 \\ 0 & 0 & 1 & 1 & 1 & 1 & 1 & 1 & 0 & 0 \\ 0 & 1 & 0 & 1 & 0 & 1 & 0 & 1 & 1 & 1 \\ 1 & 0 & 1 & 0 & 1 & 0 & 0 & 1 & 1 & 1 \\ 1 & 1 & 0 & 0 & 1 & 0 & 1 & 0 & 1 & 1 \end{bmatrix}$$

$V_0$ $V_1$ $V_2$ $V_3$ $V_4$ $V_5$ $V_6$ $V_7$ $V_8$ $V_9$

$C_0$ $C_1$ $C_2$ $C_3$ $C_4$

FIG. 3

FIG. 4

FIG. 5

[510]

[511]

[512]

Lifting size  Z

610

**Pre-processing (if required)**

620

**Bit Deinterleaving**

630

**Rate Dematching**

640

**HARQ Soft-combining**

650

**LDPC Decoding**

FIG. 6

FIG. 7

$$E' / Q_m$$

$$Q_m$$

E

E' − E

FIG. 8

FIG. 9

1010 1020 1030 1040

| LDPC Encoding | Rate Matching | Bit Interleaving | Post-processing |

E' E'

FIG. 10

$$e' \leftarrow \text{Deinterleaving} [ f', Q_m, E' ] \quad \sim 1110$$

$$e \leftarrow \text{Puncturing} [ e', E'-E ] \quad \sim 1120$$

$$f \leftarrow \text{Interleaving} [ e, Q_m, E ] \quad \sim 1130$$

FIG. 11

## INTERNATIONAL SEARCH REPORT

| International application No. |
|---|
| **PCT/KR2022/011761** |

**A. CLASSIFICATION OF SUBJECT MATTER**

**H04L 1/00**(2006.01)i; **H04L 47/34**(2022.01)i; **H04L 47/36**(2022.01)i

According to International Patent Classification (IPC) or to both national classification and IPC

**B. FIELDS SEARCHED**

Minimum documentation searched (classification system followed by classification symbols)

H04L 1/00(2006.01); H03M 13/00(2006.01); H03M 13/11(2006.01); H04N 21/2343(2011.01); H04N 21/236(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 저밀도 패리티 검사(low density parity check, LDPC), 시퀀스(sequence), 운용 단위(operation unit), 복호(decoding), 리프팅 크기(lifting size), 인터리빙(interleaving), 비트 시퀀스(bit sequence), 부호율 조정(rate-matching)

**C. DOCUMENTS CONSIDERED TO BE RELEVANT**

| Category* | Citation of document, with indication, where appropriate, of the relevant passages | Relevant to claim No. |
|---|---|---|
| A | KR 10-2020-0054249 A (ZTE CORPORATION) 19 May 2020 (2020-05-19)<br>See paragraphs [0029]-[0047]; and claim 1. | 1-15 |
| A | KR 10-2131834 B1 (LG ELECTRONICS INC.) 08 July 2020 (2020-07-08)<br>See paragraphs [0010]-[0017]; and claim 10. | 1-15 |
| A | KR 10-2194617 B1 (HUAWEI TECHNOLOGIES CO., LTD.) 24 December 2020 (2020-12-24)<br>See paragraphs [0061]-[0062]; and claim 1. | 1-15 |
| A | KR 10-2018-0122911 A (SAMSUNG ELECTRONICS CO., LTD.) 14 November 2018 (2018-11-14)<br>See paragraphs [0072]-[0096]; and claim 1. | 1-15 |
| A | KR 10-2018-0138101 A (SAMSUNG ELECTRONICS CO., LTD.) 28 December 2018 (2018-12-28)<br>See paragraphs [0012]-[0016]. | 1-15 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **01 November 2022** | **02 November 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2022/011761**

| Patent document cited in search report | | | Publication date (day/month/year) | Patent family member(s) | | | Publication date (day/month/year) |
|---|---|---|---|---|---|---|---|
| KR | 10-2020-0054249 | A | 19 May 2020 | CA | 3073980 | A1 | 14 March 2019 |
| | | | | CN | 111066252 | A | 24 April 2020 |
| | | | | EP | 3682546 | A1 | 22 July 2020 |
| | | | | EP | 3682546 | A4 | 23 September 2020 |
| | | | | JP | 2021-502718 | A | 28 January 2021 |
| | | | | US | 11233531 | B2 | 25 January 2022 |
| | | | | US | 2020-0212937 | A1 | 02 July 2020 |
| | | | | WO | 2019-047230 | A1 | 14 March 2019 |
| KR | 10-2131834 | B1 | 08 July 2020 | CN | 109792253 | A | 21 May 2019 |
| | | | | EP | 3522378 | A1 | 07 August 2019 |
| | | | | US | 10804933 | B2 | 13 October 2020 |
| | | | | US | 2019-0229751 | A1 | 25 July 2019 |
| | | | | WO | 2018-062660 | A1 | 05 April 2018 |
| KR | 10-2194617 | B1 | 24 December 2020 | AU | 2018-290395 | A1 | 19 September 2019 |
| | | | | AU | 2018-290395 | B2 | 21 May 2020 |
| | | | | BR | 112019020898 | A2 | 28 April 2020 |
| | | | | BR | 112019020898 | B1 | 15 February 2022 |
| | | | | BR | 112019026818 | A2 | 30 June 2020 |
| | | | | CN | 108712174 | A | 26 October 2018 |
| | | | | CN | 108712174 | B | 09 July 2019 |
| | | | | CN | 109150196 | A | 04 January 2019 |
| | | | | CN | 110677157 | A | 10 January 2020 |
| | | | | CN | 111052615 | A | 21 April 2020 |
| | | | | EP | 3582398 | A1 | 18 December 2019 |
| | | | | EP | 3582398 | B1 | 15 June 2022 |
| | | | | JP | 2020-516147 | A | 28 May 2020 |
| | | | | JP | 6815537 | B2 | 20 January 2021 |
| | | | | KR | 10-2019-0112129 | A | 02 October 2019 |
| | | | | MX | 2019012019 | A | 11 November 2019 |
| | | | | RU | 2019131324 | A | 05 April 2021 |
| | | | | US | 10784893 | B2 | 22 September 2020 |
| | | | | US | 2019-0349006 | A1 | 14 November 2019 |
| | | | | US | 2020-0403636 | A1 | 24 December 2020 |
| | | | | WO | 2019-001046 | A1 | 03 January 2019 |
| | | | | WO | 2019-001338 | A1 | 03 January 2019 |
| | | | | ZA | 201905739 | B | 28 July 2021 |
| KR | 10-2018-0122911 | A | 14 November 2018 | CN | 110583023 | A | 17 December 2019 |
| | | | | CN | 110583023 | B | 01 March 2022 |
| | | | | CN | 114614947 | A | 10 June 2022 |
| | | | | US | 10680652 | B2 | 09 June 2020 |
| | | | | US | 11258462 | B2 | 22 February 2022 |
| | | | | US | 11296727 | B2 | 05 April 2022 |
| | | | | US | 2018-0323807 | A1 | 08 November 2018 |
| | | | | US | 2020-0259507 | A1 | 13 August 2020 |
| | | | | US | 2022-0224359 | A1 | 14 July 2022 |
| | | | | WO | 2018-203725 | A1 | 08 November 2018 |
| KR | 10-2018-0138101 | A | 28 December 2018 | AU | 2018-288906 | A1 | 27 December 2018 |
| | | | | AU | 2018-288906 | B2 | 02 June 2022 |
| | | | | CA | 3067966 | A1 | 27 December 2018 |
| | | | | CN | 110800216 | A | 14 February 2020 |

Form PCT/ISA/210 (patent family annex) (July 2022)

**INTERNATIONAL SEARCH REPORT**
Information on patent family members

International application No.

**PCT/KR2022/011761**

| Patent document cited in search report | Publication date (day/month/year) | Patent family member(s) | | Publication date (day/month/year) |
|---|---|---|---|---|
| | | EP 3625887 A1 | | 25 March 2020 |
| | | EP 3625887 B1 | | 15 September 2021 |
| | | EP 4037193 A1 | | 03 August 2022 |
| | | ES 2901249 T3 | | 21 March 2022 |
| | | HU E056494 T2 | | 28 February 2022 |
| | | JP 2020-524464 A | | 13 August 2020 |
| | | PL 3625887 T3 | | 10 January 2022 |
| | | US 10742350 B2 | | 11 August 2020 |
| | | US 11223443 B2 | | 11 January 2022 |
| | | US 2018-0367239 A1 | | 20 December 2018 |
| | | US 2020-0322083 A1 | | 08 October 2020 |
| | | US 2022-0116135 A1 | | 14 April 2022 |
| | | WO 2018-236114 A1 | | 27 December 2018 |

Form PCT/ISA/210 (patent family annex) (July 2022)